Europäisches Patentamt

**European Patent Office**

**Office européen des brevets**

(11) Numéro de publication: **0 098 671**
**B1**

# FASCICULE DE BREVET EUROPEEN

(45) Date de publication du fascicule du brevet:
**23.04.86**

(21) Numéro de dépôt: **83201007.8**

(22) Date de dépôt: **06.07.83**

(51) Int. Cl.⁴: **H 01 L 21/31, H 01 L 27/01**

(54) **Procédé d'isolement par oxydation anodique de portions métalliques entre elles et dispositif obtenu par ce procédé.**

(30) Priorité: **09.07.82 FR 8212137**

(43) Date de publication de la demande:
**18.01.84 Bulletin 84/3**

(45) Mention de la délivrance du brevet:
**23.04.86 Bulletin 86/17**

(84) Etats contractants désignés:
**DE FR GB NL**

(56) Documents cités:
**GB - A - 2 045 526**

**PATENTS ABSTRACTS OF JAPAN, vol. 6, no. 147(E123)
(1025), 6 août 1982
30TH ELECTRONIC COMPONENTS CONFERENCE,
28-30 avril 1980, pages 402-409, San Francisco, USA,
L.G. FEINSTEIN et al.: "TA thin film capacitors with Al
underlay for high frequency applications"
PATENTS ABSTRACTS OF JAPAN, vol. 5, no. 163 (E-78)
(835), 20 octobre 1981**

(73) Titulaire: **R.T.C. LA RADIOTECHNIQUE-COMPELEC
Société anonyme dite:, 51 rue Carnot BP 301,
F-92156 Suresnes Cédex (FR)**

(84) Etats contractants désignés: **FR**

(73) Titulaire: **N.V. Philips' Gloeilampenfabrieken,
Groenewoudseweg 1, NL-5621 BA Eindhoven (NL)**

(84) Etats contractants désignés: **DE GB NL**

(72) Inventeur: **Gaulier, Yves, Société civile S.P.I.D. 209 rue
de l'Université, F-75007 Paris (FR)**

(74) Mandataire: **Pinchon, Pierre et al, Société Civile
S.P.I.D. 209 rue de L'Université, F-75007 Paris (FR)**

**Description**

La présente invention concerne un procédé d'isolement par oxydation anodique, d'une part des portions entre elles d'une première couche métallique et, d'autre part, desdites portions de cette première couche avec au moins une portion d'une seconde couche métallique, lesdites première et seconde couches métalliques, étant créées à la surface d'un corps semi-conducteur dont elles sont au moins partiellement séparées par une première couche isolante, procédé selon lequel, après dépôt de la première couche métallique, on recouvre la totalité de la surface de cette dernière, d'une seconde couche en substance isolante servant de masque lors de la réalisation de cloisons profondes verticales d'isolement et d'îlots diélectriques ayant pour buts respectifs de diviser la première couche métallique en portions isolées entre elles et d'isoler lesdites portions de cette première couche de la seconde couche métallique déposée par la suite.

La présente invention concerne également le dispositif obtenu par ce procédé.

La réalisation de certains dispositifs sur une plaquette semiconductrice, notamment la réalisation de circuits intégrés, nécessite le dépôt de couches métalliques minces sur au moins l'une des faces de ladite plaquette.

De telles couches, utilisées en particulier comme moyens de connexion ou d'interconnexion actifs ou passifs de divers éléments desdits circuits, doivent avoir une forme compatible avec la configuration du dispositif sur lequel elles sont déposées. Pour leur donner cette forme, on utilise, le plus souvent, un procédé dit d'oxydation anodique localisée d'un métal ou d'un alliage de métaux dont l'oxyde présentera les propriétés nécessaires d'isolement électrique. Généralement, le métal le plus utilisé est l'aluminium. Dans ces conditions, il est possible de créer des dispositifs comportants non seulement, dans une même couche, une pluralité de réseaux métalliques isolés les uns des autres mais également de multiples couches superposées et isolées entre elles.

Un exemple de ce type d'applications est décrit dans le brevet US N° 3 798 135 qui concerne la superposition d'une pluralité de portions de couches métalliques isolées entre elles transversalement et latéralement par des cloisons verticales et des îlots diélectriques obtenus à partir d'aluminium anodisé.

De même que les autres procédés déjà connus, celui décrit dans ledit brevet US 3 798 135 présente de multiples inconvénients et l'un des principaux réside dans le fait que, après la réalisation des réseaux métalliques et isolants à la surface du corps semi conducteur, ce dernier est soumis à diverses opérations mécaniques et notamment à des opérations de rodage effectuées en prenant pour référence la face active et les couches qui la recouvrent: or, dans les structures actuelles, sous l'effet de la pression exercées sur la surface de référence, les cloisons verticales et les îlots diélectriques localisés séparant transversalement et latéralement les portions métalliques, s'enfoncent légèrement dans lesdites portions des couches métalliques dans lesquelles ils ont été créés et peuvent être détériorés.

Ce phénomène, qui est particulièrement sensible à la périphérie desdits îlots peut provoquer des courts-cirquits entre des portions de couches superposées ou entre des portions de couches voisines.

Une solution envisagée pour remédier à cet inconvénient consiste à recouvrir les îlots diélectriques et les cloisons verticales d'isolement d'une couches isolante supplémentaire, ce qui conduit donc à ajouter des opérations de dépôt et de photogravure au mode opératoire existant et augmente donc la complexité de la mise en œuvre.

La présente invention a pour but de pallier ces difficultés et, pour ce faire, prend en considération les phénomènes apparaissant lors des opérations de photogravure.

La présente invention a également pour but de réaliser des condensateurs intégrables dans une structure multicouche par des opérations simples, reproductibles et compatibles avec la réalisation simultanée des autres éléments de ladite structure, lesdits condensateurs devant présenter une haute valeur de permittivité.

Pour ce faire, l'invention utilise le procédé connu d'oxydation anodique d'un métal de bonne conductivité électrique plongé dans une solution électrolytique appropriée, et soumis à l'effet d'une tension extérieure dont la valeur détermine les caractéristiques capacitives des condensateurs.

En effet, la présente invention concerne un procédé d'isolement par oxydation anodique, d'une part, des portions entre elles d'une première couche métallique et, d'autre part, desdites portions de cette première couche avec au moins une portion d'une seconde couche métallique, lesdites première et seconde couches métalliques étant créées à la surface d'un corps semi-conducteur dont elles sont au moins partiellement séparées par une première couche isolante, procédé selon lequel, après dépôt de la première couche métallique, on recouvre la totalité de la surface de cette dernière d'une seconde couche en substance isolante servant de masque lors de la réalisation de cloisons profondes verticales d'isolement et d'îlots diélectriques ayant pour buts respectifs de diviser la première couche métallique en portions isolées entre elles, et d'isoler lesdites portions de cette première couche de la seconde couche métallique déposée par la suite, notamment remarquable en ce que, par une première série d'ouverture pratiquées dans ladite seconde couche isolante, on évide localement la première couche métallique pour y créer des creusures à partir de la surface desquelles on forme par oxydation anodique les couches diélectriques en forme d'îlots, puis en ce que, par une seconde série d'ouvertures pratiquées dans la même seconde couche en substance isolante, on creuse dans la première couche métallique de nouveaux évidements à partir de la surface desquels on crée les cloisons profondes verticales d'isolement et, enfin, en ce que l'on dépose sur l'ensemble, la seconde couche métallique que l'on photograve pour former notamment des portions qui, associées aux portions de la première couche métallique et aux îlots diélectriques constituent des condensateurs isolés entre eux par les cloisons profondes verticales d'isolement.

Le premièr avantage de ce procédé réside dans le

fait que sa mise en œuvre ne nécessite pas d'opérations de dépôt et/ou de photogravure supplémentaires: en effet, les mêmes ouvertures pratiquées dans la couche en substance isolante pour la gravure de la couche métallique sont utilisées pour l'anodisation localisée de ladite couche.

En second lieu, dans la mise en œuvre du procédé, on met automatiquement à profit le fait qu'une gravure latérale, dite sous-gravure, apparaît simultanément à la gravure transversale. Cette gravure, qui s'étend sous la couche en substance isolante, fait que l'îlots localisé d'oxyde anodisé est parfaitement protégé à sa périphérie, notamment lorsqu'une pression est exercée en surface lors des dernières opérations de mise à épaisseur.

Les opérations d'anodisation sont effectuées à basse température de telle sorte que les caractéristiques physiques et électriques de la structure comportant les diverses couches métalliques ne sont pas altérées.

La présente invention concerne également le dispositif obtenu par le procédé décrit ci-dessus et comportant une structure intégrée d'éléments actifs et passifs à la surface de laquelle a été créée une pluralité de condensateurs isolés les uns des autres par des cloisons profondes verticales d'isolement et dont les armatures de chacun d'entre eux sont séparées par une couche diélectrique en forme d'îlot, la couche diélectrique et les cloisons profondes verticales d'isolement ayant été obtenues par oxydation anodique localisée d'une couche superficielle de l'armature inférieure desdits condensateurs, à travers des ouvertures pratiquées dans une couche en substance isolante recouvrant ladite armature, dispositif notamment remarquable en ce que la surface externe des îlots localisés constituant la couche diélectrique et celle des cloisons profondes verticales d'isolement présentent au moins partiellement une dénivellation par rapport à la surface de l'armature inférieure des condensateurs, et en ce que la couche en substance isolante recouvrant ladite armature inférieure surplombe la périphérie des évidements ainsi créés.

De préférence, les couches métalliques servant à la création des armatures des condensateurs intégrés sont en aluminium ce qui implique, par ailleurs, que les îlots diélectriques séparant des portions de couches métalliques superposées sont en alumine étanche alors que les cloisons profondes verticales d'isolement séparant des portions d'une même couche métallique sont en alumine poreuse, l'alumine étant un oxyde caractérisé par une haute permittivité et l'alumine étanche obtenue entre les portions métalliques superposées permettant d'éviter la diffusion du métal constituant les dites portions.

La description qui va suivre, en regard des figures décrivant des exemples non limitatifs, fera bien comprendre comment l'invention peut être réalisée.

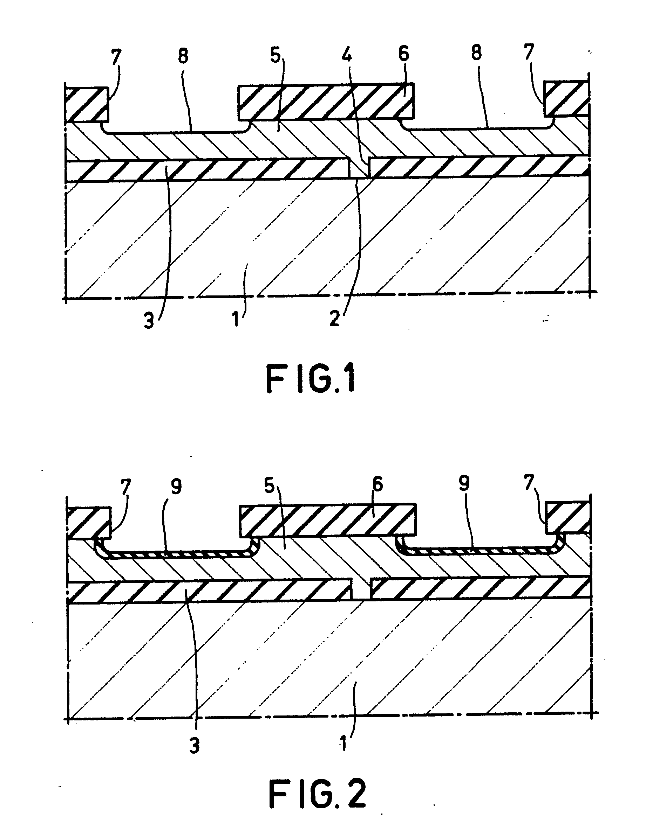

Les figures 1 à 4 représentent schématiquement et en coupe diverses étapes de la réalisation d'un dispositif semiconducteur comportant une pluralité de condensateurs MOM obtenus par la mise en œuvre du procédé selon l'invention.

Il est à noter que, sur les figures, les dimensions sont considérablement exagérées et non proportionnées, ceci afin de rendre les dessins plus clairs.

Dans l'exemple illustré par lesdites figures 1 à 4, on part d'une plaquette semiconductrice 1 dans laquelle on a créé des éléments actifs et passifs non représentés sur lesdites figures.

A la surface 2 de ladite plaquette, on dépose une première couche isolante 3, généralement de $SiO_2$ dans laquelle on pratique des ouvertures 4 nécessaires à la prise de contacts sur lesdits éléments actifs et passifs.

On recouvre ensuite la surface de la couche isolante 3 et les ouvertures 4 d'une couche d'aluminium 5 constituant la couche métallique dans laquelle seront traitées les armatures inférieures des condensateurs à réaliser.

Cette couche métallique sert également à former une première nappe de réseaux de connexions en contact avec les éléments actifs et passifs du dispositif par l'intermédiaire des ouvertures 4.

Après avoir réalisé lesdits réseaux de connexions, l'opération suivante consiste à recouvrir l'ensemble d'une seconde couche 6 en substance isolante dans laquelle on pratique des ouvertures 7 par lesquelles on attaque ensuite chimiquement la couche métallique sous-jacente 5.

Du fait de cette attaque chimique, on obtient les évidements 8 dont la périphérie, en raison du phénomène dit de «sous-gravure», se trouve surplombée par la couche en substance isolante 6 (figure 1).

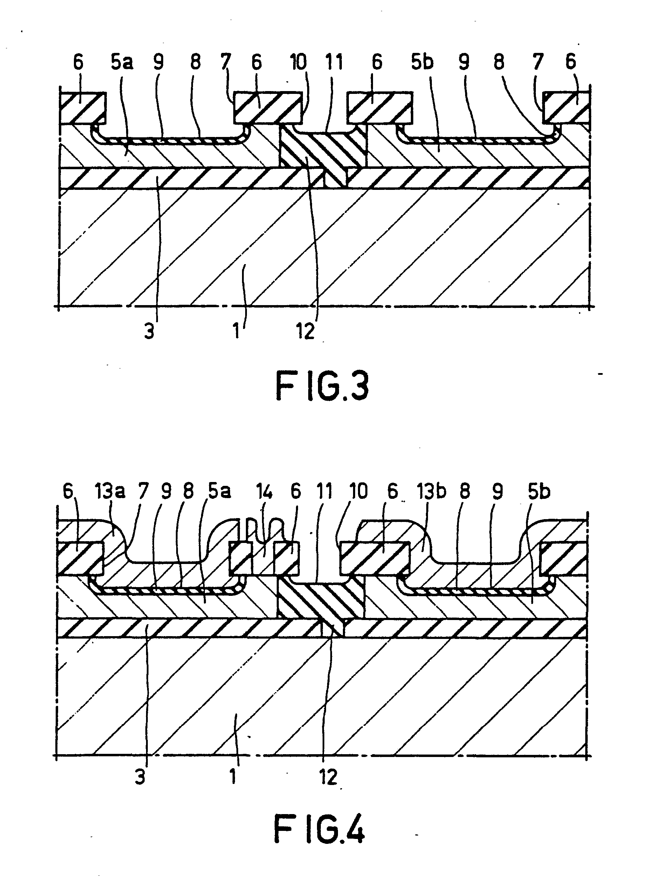

On traite alors la surface mise à nu dans les évidements 8 par anodisation de manière à obtenir les pellicules 9 d'alumine étanche qui constituent la couche diélectrique des futurs condensateurs MOM (figure 2). Ces pellicules 9 d'alumine sont formées dans une solution aqueuse d'acide tartrique à 30 g/litre et de $pH = 1,8$ sous une tension choisie en fonction de l'épaisseur à obtenir à raison de 10 Å/volt: ladite tension est choisie dans cet exemple aux environs de 25 V.

Après réalisation de la couche diélectrique 9, on pratique de nouvelles ouvertures 10 dans la couche en substance isolante 6. Ces ouvertures 10 se situent entre les ouvertures 7 déjà pratiquées précédemment et par lesdites ouvertures 10, on procède, en premier lieu, à une attaque chimique permettant de creuser des évidements 11 à partir desquels seront créés les îlots localisés 12 d'alumine poreuse (cloisons profondes verticales d'isolement) qui déterminent, en fait, la configuration des armatures inférieures 5a, 5b... et donc de la pluralité des condensateurs MOM (figure 3). Ces îlots d'isolement 12 traversent la totalité de l'épaisseur de la couche métallique 5 et sont obtenus, par example, par anodisation dans une solution d'acide oxalique à 80 g/litre.

Les dernières opérations qui conduisent à la représentation de la figure 4 consistent ensuite à réaliser les secondes armatures 13a, 13b desdits condensateurs, les prises de contact 14 sur la première armature et une nouvelle nappe de réseaux de connexions à partir d'un dépôt d'une seconde couche métallique, généralement d'aluminium, déposée à la surface de l'ensemble et photogravée de manière appropriée.

On constate ainsi, sur la figure 4, que l'on a donc obtenu une succession de condensateurs à la surface de structure intégrée, le branchement desdits con-

densateurs en série ou en parallèle étant alors réalisé à partir de liaisons extérieures.

## Revendications:

1. Procédé d'isolement par oxydation anodique, d'une part, des portions entre elles (5a, 5b) d'une première couche métallique (5) et, d'autre part, desdites portions de cette première couche avec au moins une portion d'une seconde couche métallique, lesdites première et seconde couches métalliques étant créées à la surface d'un corps semiconducteur (1) dont elles sont au moins partiellement séparées par une première couche isolante (3), procédé selon lequel, après dépôt de la première couche métallique (5), on recouvre la totalité de la surface de cette dernière d'une seconde couche en substance isolante (6) servant de masque lors de la réalisation de cloisons profondes verticales d'isolement (12) et d'îlots diélectriques (9) ayant pour buts respectifs de diviser la première couche métallique (5) en portions (5a, 5b) isolées entre elles et d'isoler lesdites portions de cette première couche (5) de la seconde couche métallique déposée par la suite, caractérisé en ce que, par une première série d'ouvertures (7) pratiquées dans ladite seconde couche en substance isolante (6), on évide localement la première couche métallique (5) pour y créer des creusures (8) à partir de la surface desquelles on forme par oxydation anodique les couches diélectriques en forme d'îlots (9), puis en ce que, par une seconde série d'ouvertures (10) pratiquées dans la même seconde couche en substance isolante (6), on creuse dans la première couche métallique (5) de nouveaux évidements (11) à partir de la surface desquels on crée les cloisons profondes verticales d'isolement (12) et, enfin, en ce que l'on dépose sur l'ensemble, la seconde couche métallique que l'on photograve pour former notamment des portions (13a, 13b) qui, associées aux portions (5a, 5b) de la première couche métallique (5) et aux îlots diélectriques (9) constituent des condensateurs isolés entre eux par les cloisons profondes verticales d'isolement (12).

2. Dispositif obtenu par le procédé conforme à la revendication 1 et comportant une structure intégrée d'éléments actifs et passifs à la surface de laquelle a été créée une pluralité de condensateurs isolés les uns des autres par des cloisons profondes verticales d'isolement (12) et dont les armatures (5a, 5b, 13a, 13b...) de chacun d'entre eux sont séparées par une couche diélectrique (9) en forme d'îlots, la couche diélectrique (9) et les cloisons profondes verticales d'isolement (12) ayant été obtenues par oxydation anodique localisée d'une couche superficielle de l'armature inférieure (5) desdits condensateurs à travers des ouvertures (7, 10) pratiquées dans une couche en substance isolante (6) recouvrant ladite armature, dispositif caractérisé en ce que la surface externe des îlots localisés constituant la couche diélectrique (9) et celle des cloisons profondes verticales d'isolement (12) présentent au moins partiellement une dénivellation par rapport à la surface de l'armature inférieure (5a, 5b...) des condensateurs, et en ce que la couche en substance isolante (6) recouvrant ladite armature surplombe la périphérie des évidements (8, 11) ainsi créés.

3. Dispositif selon la revendication 2, caractérisé en ce que les couches métalliques servant à la création des armatures (5a, 5b, 13a, 13b) des condensateurs intégrés sont en aluminium.

4. Dispositif selon l'une des revendications 2 et 3 caractérise en ce que les îlots diélectriques sont en alumine étanche et en ce que les cloisons profondes verticales d'isolement (12) sont en alumine poreuse.

## Patentansprüche:

1. Verfahren zum Isolieren einerseits zwischen Teinen (5a, 5b) einer ersten metallischen Schicht (5) und andererseits zwischen diesen Teilen dieser ersten Schicht und zumindest einem Teil einer zweiten metallischen Schicht durch anodische Oxydation, wobei diese ersten und zweiten metallischen Schichten auf der Oberfläche eines Halbleiterkörpers (1) angebracht sind, von dem sie zumindest teilweise durch eine erste Isolierschicht (3) getrennt sind, bei welchem Verfahren nach der Ablagerung der ersten metallischen Schicht (5) die gesamte Oberfläche dieser ersten Schicht mit einer zweiten aus isolierendem Werkstoff (6) bestehenden Schicht bedeckt wird, die als Maske bei der Verwirklichung von tief durchdringenden vertikalen isolierenden Trennwänden (12) und dielektrischer Inseln (9) zum Verteilen der ersten metallischen Schicht (5) in voneinander isolierte Teile (5a, 5b) bzw. zum Isolieren dieser Teile der ersten Schicht (5) von der darauf angelagerten zweiten metallischen Schicht dient, dadurch gekennzeichnet, dass durch eine erste Reihe von Öffnungen (7) in der genannten zweiten, aus isolierendem Werkstoff (6) bestehenden Schicht stellenweise die erste metallische Schicht (5) zur Bildung von Hohlräumen (8) ausgenommen wird, wobei ausgehend von der Oberfläche dieser Hohlräume durch anodische Oxydation die dielektrischen Schichten in Inselform (9) gebildet werden, und anschliessend durch eine zweite Reihe von Öffnungen (10) in der selben zweiten Schicht (6) aus isolierendem Werkstoff in der ersten metallischem Schicht (5) erneut Hohlräume (11) gebildet werden, wobei ausgehend von der Oberfläche dieser Hohlräume die tief durchgehenden vertikalen isolierenden Trennwände (12) gebildet werden, und schliesslich dass auf diesem Gebilde die zweite metallischen Schicht aufgedampft wird, die zur Bildung insbesondere der Teile (13a, 13b) ausgeätzt wird, die im Zusammenhang mit den Teilen (5a, 5b) der ersten metallischen Schicht (5) und mit den dielektrischen Inseln (9) voneinander isolierte Kondensatoren durch die tief durchgehenden vertikalen isolierenden Trennwände (12) bilden.

2. Anordnung, hergestellt im Verfahren nach Anspruch 1, mit einer aus aktiven und passiven Elementen bestehenden integrierten Struktur, auf deren Oberfläche eine Anzahl voneinander durch die tief durchgehenden vertikalen isolierenden Trennwände (12) isolierter Kondensatoren gebildet ist und deren Teile (5a, 5b, 13a, 13b...) voneinander durch eine dielektrische Schicht (9) in Inselform getrennt sind, wobei die dielektrische Schicht (9) und die tief durchgehenden vertikalen isolierenden Trennwände (12) durch stellenweise anodische Oxydation einer Oberflächenschicht des unteren Teiles (5) dieser Kondensatoren durch Öffnungen (7, 10) in einer aus isolierendem Werkstoff bestehenden Schicht (6) erhalten werden, die diesen Teil bedecken, dadurch gekennzeichnet, dass die Aussenfläche der lokalisierten, die dielektrische Schicht (9) bildenden Inseln und die Aussenfläche der tief durchgehenden isolierenden vertikalen Trennwände (12) zumindest teilweise einen Niveauunterschied in bezug auf die Oberfläche des unteren Teiles (5a, 5b...) der Kondensatoren aufweisen, und dass die aus isolierendem Werkstoff (6) bestehende Schicht diesen Teil bedeckt und senkrecht zur Peripherie der so gebildeten Ausnehmungen (8, 11) verläuft.

3. Anordnung nach Anspruch 2, dadurch gekennzeichnet, dass die metallischen Schichten zur Bildung der Teile (5a, 5b, 13a, 13b) der integrierten Kondensatoren aus Aluminium bestehen.

4. Anordnung nach einem der Ansprüche 2 und 3, dadurch gekennzeichnet, dass die dielektrischen Inseln aus dichtem Aluminium und die tief durchgehenden vertikalen isolierenden Trennwände (12) aus porösem Aluminium bestehen.

**Claims:**

1. A method of insulating by anodic oxidation on the one hand parts (5a, 5b) of a first metal layer (5) from each other and on the other hand the said parts of this first layer from at least one part of a second metal layer, the said first and second metal layers being formed at the surface of a semiconductor body (1), from which they are separated at least in part by a first insulating layer (3), according to which method, after the first metal layer (5) has been deposited, the whole surface of the latter is covered by a second layer of insulating material (6) serving as a mask during the formation of deep vertical insulating partition walls (12) and of dielectric islands (9) having for their respective objects to divide the first metal layer (5) into parts (5a, 5b) insulated from each other and to insulate the said parts of this first layer (5) from the second metal layer then deposited, characterized in that the first metal layer (5) is locally provided with recesses through a first series of openings (7) formed in the said second layer of insulating material (6) in order to form therein cavities (8), from whose surfaces the dielectric layers in the form of islands (9) are formed by anodic oxidation, in that then new recesses (11) are formed in the first metal layer (5) through a second series of openings (10) formed in the same second layer of insulating material (6), the deep vertical insulating partition walls (12) being formed from the surfaces of these recesses, and in that finally on the assembly the second metal layer is deposited, which is subjected to photo-etching in order to form especially parts (13a, 13b) which, associated with the parts (5a, 5b) of the first metal layer (5) and with the dielectric islands (9), constitute capacitors insulated from each other by deep vertical insulating partition walls (12).

2. A device obtained by the method claimed in Claim 1 and comprising an integrated structure of active and passive elements, at the surface of which a plurality of capacitors are formed, which are insulated from each other by deep vertical insulating partition walls (12) and whose plates (5a, 5b, 13a, 13b...) are all separated from each other by a dielectric island-shaped layer (9), the dielectric layer (9) and the deep vertical insulating partition walls (12) having been obtained by local anodic oxidation of a superficial layer of the lower plate (5) of the said capacitors through the openings (7, 10) formed in a layer of insulating material (6) covering the said plate, which device is characterized in that the outer surface of the local islands constituting the dielectric layer (9) and that of the deep vertical insulating partition walls (12) exhibits at least in part a difference in level with respect to the surface of the lower plate (5a, 5b...) of the capacitors, and in that the layer of insulating material (6) covering the said plate is arranged straight above the periphery of the recesses (8, 11) thus formed.

3. A device as claimed in Claim 2, characterized in that the metal layers serving to form the plates (5a, 5b, 13a, 13b) of the integrated capacitors consist of aluminium.

4. A device as claimed in any one of Claims 2 and 3, characterized in that the dielectric islands consist of tight aluminium and in that the deep vertical insulating partition walls (12) consist of porous alumina.

FIG.1

FIG.2

FIG.3

FIG.4